(19) Europäisches Patentamt / European Patent Office / Office européen des brevets

(11) **EP 4 224 183 A1**

(12) **EUROPEAN PATENT APPLICATION**
published in accordance with Art. 153(4) EPC

(43) Date of publication:
**09.08.2023 Bulletin 2023/32**

(21) Application number: **21874313.6**

(22) Date of filing: **22.09.2021**

(51) International Patent Classification (IPC):
**G01R 31/387** (2019.01)

(52) Cooperative Patent Classification (CPC):
**G01R 31/367; G01R 31/387; G01R 31/388;
H02J 7/00;** Y02T 10/70; Y02T 90/167; Y04S 30/12

(86) International application number:
**PCT/CN2021/119637**

(87) International publication number:
**WO 2022/068652 (07.04.2022 Gazette 2022/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.09.2020 CN 202011066177**

(71) Applicant: **BYD Company Limited
Shenzhen, Guangdong 518118 (CN)**

(72) Inventors:
• **LIAN, Yubo
Shenzhen, Guangdong 518118 (CN)**
• **LING, Heping
Shenzhen, Guangdong 518118 (CN)**
• **CHEN, Siliang
Shenzhen, Guangdong 518118 (CN)**
• **WANG, Zhengzheng
Shenzhen, Guangdong 518118 (CN)**
• **LI, Junzi
Shenzhen, Guangdong 518118 (CN)**

(74) Representative: **DehnsGermany Partnerschaft
von Patentanwälten
Theresienstraße 6-8
80333 München (DE)**

(54) **METHOD AND APPARATUS FOR OBTAINING BATTERY CAPACITY, STORAGE MEDIUM AND SERVER**

(57) A method and a device for acquiring a battery capacity, a storage medium, and a server are provided. The method includes: acquiring multiple initial charging parameters when a current charging process of a vehicle battery is effective charging, where the effective charging means that the range of variation in state of charge (SOC) of the battery covers a preset SOC range, and the minimum charging temperature of the battery is greater than or equal to a preset temperature threshold; periodically acquiring multiple actual charging parameters of the battery and a current number of effective charging times corresponding to the current charging process; and acquiring, according to the multiple initial charging parameters, the multiple actual charging parameters and the current number of effective charging times, a predicted battery capacity of the battery in a next effective charging process.

EP 4 224 183 A1

FIG. 1

**Description**

**CROSS-REFERENCE TO RELATED APPLICATIONS**

The present disclosure is proposed on the basis of and claims priority to Chinese Patent Application No. 202011066177.3 filed on September 30, 2020 and entitled "Method and device for acquiring battery capacity, storage medium, and server", the disclosure of which is incorporated herein by reference in its entirety.

**FIELD**

The present disclosure relates to the technical field of batteries, and specifically to a method and a device for acquiring a battery capacity, a storage medium, and a server.

**BACKGROUND**

Electric vehicles are motor vehicles completely or partially powered by power batteries. The battery capacity of a power battery is an important factor affecting the performance of electric vehicles, and the accurate estimation of the battery capacity can improve the estimation accuracy of state of charge (SOC), the prediction accuracy of peak power and the estimation accuracy of cruising range. Therefore, in a battery management system, the battery capacity is often used as an important indicator charactering the battery health.
In the related art, the battery capacity of a battery can be calculated according to the charging and discharging current of a battery pack. However, this method requires the detection of open circuit voltage (OCV) and OCV can be obtained only after charging and discharging with small current and fully standing. The acquisition time is long, causing a low efficiency in the estimation of the battery capacity.

**SUMMARY**

To solve the above problems, the present disclosure provides a method and a device for acquiring a battery capacity, a storage medium, and a server.
In a first aspect, the present disclosure provides a method for acquiring a battery capacity, which includes: acquiring multiple initial charging parameters of a vehicle battery when a current charging process of the battery is effective charging, where the effective charging means that the range of variation in SOC of the battery in the current charging process covers a preset SOC range, and the minimum charging temperature of the battery in the current charging process is greater than or equal to a preset temperature threshold; periodically acquiring multiple actual charging parameters of the battery in the current charging process and a current number of effective charging times corresponding to the current charging process; and acquiring, according to the multiple initial charging parameters, the multiple actual charging parameters and the current number of effective charging times, a predicted battery capacity of the battery in a next effective charging process.
Optionally, the step of acquiring, according to the multiple initial charging parameters, the multiple actual charging parameters and the current number of effective charging times, a predicted battery capacity of the battery in a next effective charging process includes estimating, according to the multiple initial charging parameters and the multiple actual charging parameters, a current maximum usable capacity of the battery; acquiring, according to the current maximum usable capacity and the current number of effective charging times, a capacity correlation relation, where the capacity correlation relation includes a correspondence relation between the predicted battery capacity and the number of effective charging times; and acquiring, according to the capacity correlation relation, the predicted battery capacity of the battery in the next effective charging process.
Optionally, the step of estimating, according to the multiple initial charging parameters and the multiple actual charging parameters, a current maximum usable capacity of the battery includes: acquiring, according to the initial charging parameters, an initial capacity increment profile; acquiring, according to the actual charging parameters, an actual capacity increment profile; and estimating, according to the initial capacity increment profile and the actual capacity increment profile, the current maximum usable capacity of the battery.
Optionally, the step of estimating, according to the initial capacity increment profile and the actual capacity increment profile, the current maximum usable capacity of the battery includes: acquiring first initial position information corresponding to a second peak value and second initial position information corresponding to a third peak value on the initial capacity increment profile; acquiring first current position information corresponding to a second peak value and second current position information corresponding to a third peak value on the actual capacity increment profile; and estimating, according to the first initial position information, the second initial position information, the first current position information, the second current position information, the initial charging parameters and the actual charging parameters, the current maximum usable capacity of the battery.

Optionally, the step of acquiring, according to the capacity correlation relation, the predicted battery capacity of the battery in the next effective charging process includes acquiring a target number of charging times corresponding to the next effective charging process; and acquiring, according to the target number of charging times and the capacity correlation relation, the predicted battery capacity of the battery in the next effective charging process.

Optionally, before the step of acquiring, according to the current maximum usable capacity and the current number of effective charging times, a capacity correlation relation, the method further includes: acquiring a historical maximum usable capacity in various effective charging processes before the current charging process and a historical number of effective charging times corresponding to the historical maximum usable capacity. The step of acquiring, according to the current maximum usable capacity and the current number of effective charging times, a capacity correlation relation includes: acquiring, according to the current maximum usable capacity, the current number of effective charging times, the historical maximum usable capacity and the historical number of effective charging times, the capacity correlation relation.

In a second aspect, the present disclosure provides a device for acquiring a battery capacity, which includes: an initial parameter acquisition module, configured to acquire multiple initial charging parameters of a vehicle battery when a current charging process of the battery is effective charging, where the effective charging means that the range of variation in SOC of the battery in the current charging process covers a preset SOC range, and the minimum charging temperature of the battery in the current charging process is greater than or equal to a preset temperature threshold; an actual parameter acquisition module, configured to periodically acquire multiple actual charging parameters of the battery in the current charging process and a current number of effective charging times corresponding to the current charging process; and a battery capacity acquisition module, configured to acquire, according to the multiple initial charging parameters, the multiple actual charging parameters and the current number of effective charging times, a predicted battery capacity of the battery in a next effective charging process.

Optionally, the battery capacity acquisition module is further configured to: estimate, according to the multiple initial charging parameters and the multiple actual charging parameters, a current maximum usable capacity of the battery; acquire, according to the current maximum usable capacity and the current number of effective charging times, a capacity correlation relation, where the capacity correlation relation includes a correspondence relation between the predicted battery capacity and the number of effective charging times; and acquiring, according to the capacity correlation relation, the predicted battery capacity of the battery in the next effective charging process.

Optionally, the battery capacity acquisition module is further configured to: acquire, according to the initial charging parameters, an initial capacity increment profile; acquire, according to the actual charging parameters, an actual capacity increment profile; and estimate, according to the initial capacity increment profile and the actual capacity increment profile, the current maximum usable capacity of the battery.

Optionally, the battery capacity acquisition module is further configured to: acquire first initial position information corresponding to a second peak value and second initial position information corresponding to a third peak value on the initial capacity increment profile; acquire first current position information corresponding to a second peak value and second current position information corresponding to a third peak value on the actual capacity increment profile; and estimate, according to the first initial position information, the second initial position information, the first current position information, the second current position information, the initial charging parameters and the actual charging parameters, the current maximum usable capacity of the battery.

Optionally, the battery capacity acquisition module is further configured to: acquire a target number of charging times corresponding to the next effective charging process; acquire, according to the target number of charging times and the capacity correlation relation, the predicted battery capacity of the battery in the next effective charging process.

Optionally, the device further includes: a historical parameter acquisition module, configured to acquire a historical maximum usable capacity in various effective charging processes before the current charging process and a historical number of effective charging times corresponding to the historical maximum usable capacity. The battery capacity acquisition module is further configured to: acquire, according to the current maximum usable capacity, the current number of effective charging times, the historical maximum usable capacity and the historical number of effective charging times, the capacity correlation relation.

In a third aspect, the present disclosure provides a computer readable storage medium, on which a computer program is stored. The computer program, when executed by a processor, implements steps of the method for acquiring a battery capacity according to the present disclosure.

In a fourth aspect, the present disclosure provides a server, which includes a: a memory, and on which a computer program is stored; and a processor, configured to execute the computer program in the memory, to implement steps of the method for acquiring a battery capacity according to the present disclosure.

Through the above technical solutions, multiple initial charging parameters of a vehicle battery are acquired when a current charging process of the battery is effective charging, where the effective charging means that the range of variation in SOC of the battery in the current charging process covers a preset SOC range, and the minimum charging temperature of the battery in the current charging process is greater than or equal to a preset temperature threshold; multiple actual charging parameters of the battery in the current charging process and a current number of effective charging times corresponding to the current charging process are periodically acquired; and a predicted battery capacity of the battery in a next effective charging process is acquired according to the multiple initial charging parameters the multiple actual charging parameters and the current number of effective charging times. As such, the charging parameters of the battery can be acquired in an effective charging process of the battery with no need to stand still, to estimate a predicted battery capacity of the battery in a next effective charging process. Therefore, the efficiency of estimating the battery capacity is improved.

Other features and advantages of the present disclosure will be described in detail in the following detailed description.

## BRIEF DESCRIPTION OF THE DRAWINGS

The accompanying drawings are intended to provide further understanding of the present disclosure and constitute a part of this specification. The accompanying drawings, together with the following detailed description, serve to explain the present disclosure, and do not constitute a restriction on the present disclosure. In the accompanying drawings,

FIG. 1 is a flow chart of a method for acquiring a battery capacity according to an exemplary embodiment;
FIG. 2 is a flow chart of another method for acquiring a battery capacity according to an exemplary embodiment;
FIG. 3 is a schematic diagram showing an interval capacity integral value according to an exemplary embodiment;
FIG. 4 is a schematic diagram showing a maximum usable capacity according to an exemplary embodiment;
FIG. 5 is a schematic structural diagram of a device for acquiring a battery capacity according to an exemplary embodiment;
FIG. 6 is a schematic structural diagram of another device for acquiring a battery capacity according to an exemplary embodiment; and
FIG. 7 is a block diagram of a server according to an exemplary embodiment.

## DETAILED DESCRIPTION

Specific implementations of the present disclosure are described in detail below with reference to the accompanying drawings. It should be understood that the specific implementations described herein are merely used to describe and explain the present disclosure, but not intended to limit the present disclosure.

In the description below, the words "first", "second", and others are merely used for the purpose of distinctive description, and cannot be interpreted as indicating or implying relative importance, or indicating or implying the sequence.

First, the application scenario of the present disclosure is described. The present disclosure is applicable to a scenario where the battery capacity is estimated. The battery capacity reflects a current health state of a battery. Due to the failure to achieve full charge and discharge achievable under laboratory conditions, complex and changeable working conditions, aging of the battery, different battery material systems and other factors in practical use, the estimation of battery capacity has become a great challenge and an important task.

In the related art, the OCV and capacity of a battery can be obtained by system identification algorithm base on a mathematical model of the battery. If the standing time of the battery pack exceed a preset time, OCV is detected. The range of variation of battery capacity in each time interval is calculated, and the range of variation of battery capacity is calculated according to OCV lookup table. The weight of battery capacity attenuation is calculated according to the two variables calculated above, and the current battery capacity is calculated according to the weight and the battery capacity at a previous moment. In this method, the estimation efficiency of the battery capacity is low, and the dependence on the sampling accuracy of current, voltage, and temperature of the battery is high, causing a low estimation accuracy of battery capacity.

To solve the above problems, the present disclosure provides a method and a device for acquiring a battery capacity, a storage medium, and a server. In a charging process of a vehicle, multiple actual charging parameters and a current number of effective charging times corresponding to the current charging process of a battery are acquired; and according to multiple initial charging parameters, the multiple actual charging parameters and the current number of effective charging times, a predicted battery capacity of the battery in a next effective charging process can be obtained. As such, the charging parameters of the battery can be acquired in an effective charging process of the battery with no need to stand still, to estimate a predicted battery capacity of the battery in a next effective charging process. Therefore, the efficiency of estimating the battery capacity is improved.

Specific implementations of the present disclosure are described in detail below with reference to the accompanying drawings.

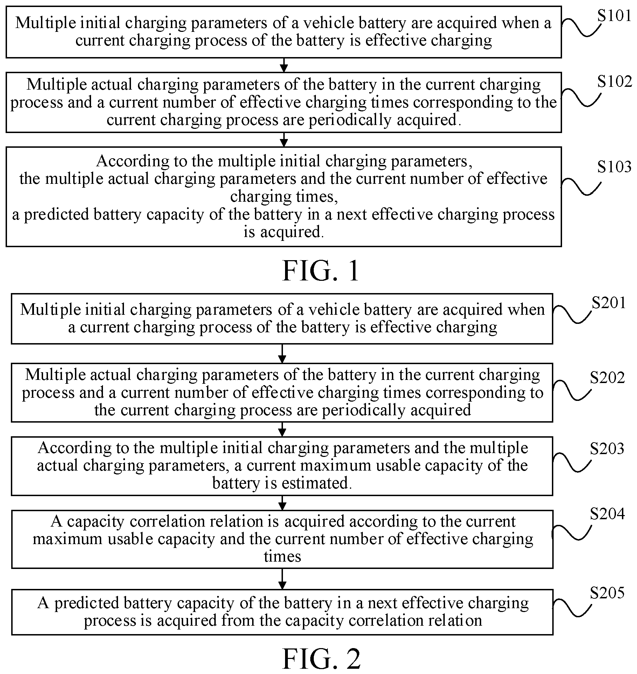

FIG. 1 is a flow chart of a method for acquiring a battery capacity according to an exemplary embodiment. As shown in FIG. 1, the method includes:

S101: Multiple initial charging parameters of a vehicle battery are acquired when a current charging process of the battery is effective charging.

The battery may be a power battery pack, the effective charging means that the range of variation in SOC of the battery in the current charging process covers a preset SOC range, and the minimum charging temperature of the battery in the current charging process is greater than or equal to a preset temperature threshold. The preset SOC range and the preset temperature threshold can be determined according to the material of the battery, and actual working conditions during use. Illustratively, a capacity increment profile of the battery includes three peaks, i.e. a first peak value, a second peak value and a third peak value. As can be known from the characteristics of power lithium ion batteries and the empirical data during practical application, the first peak value usually appears in the range of 0 to 20% SOC of the battery, and the second peak value and the third peak value usually appear in the range of 20% to 90% SOC of the battery, during the charging process of the battery. However, the battery is generally charged in an SOC range of more than 20% during practical use. Based on this, a predicted battery capacity of the battery in a next effective charging process can be acquired according to position information of the second peak value and position information of the third peak value in the present disclosure. Therefore, the preset SOC range can be set to a range including the second peak value and the third peak value, for example, 20% to 90%; and the preset temperature threshold may be 10 °C, which are not limited in the present disclosure. If the range of variation in SOC of the battery is from 15% to 90% in the current charging process and the minimum charging temperature of the battery in the current charging process is 15 °C, it can be determined that the current charging process is effective changing. If the range of variation in SOC of the battery is from 15% to 80% in the current charging process and the minimum charging temperature of the battery in the current charging process is 7 °C, it can be determined that the current charging process is ineffective changing.

In this step, after the current charging process is completed, whether the current charging process is effective charging can be determined. If the current charging process is determined to be effective charging, multiple initial charging parameters of the battery are acquired. Illustratively, after the current charging process is completed, the range of variation in SOC and the minimum charging temperature of the battery in the current charging process can be acquired. If it is determined that the range of variation in SOC includes the preset SOC range and the charging temperature of the battery is greater than or equal to the preset temperature threshold, multiple initial charging parameters of the battery are acquired. The multiple initial charging parameters can be pre-stored in a server.

It should be noted that the initial charging parameters may be standard charging parameters obtained during the full discharging and full charging process of the battery. After the full discharging and full charging of the battery, the battery capacity of the battery can reach a maximum capacity. However, in normal use, the charging process of the battery is difficult to meet the conditions of fully discharging and fully charging. Therefore, a current maximum usable capacity of the battery during normal use cannot reach the maximum capacity, and the current maximum usable capacity will be less than the maximum capacity. If a battery manager regards the maximum capacity as the current maximum available capacity, a battery safety accident will be caused due to the low accuracy of the current maximum usable capacity. Therefore, the predicted battery capacity of the battery needs to be acquired. Here, the predicted battery capacity of the battery can be acquired from the initial charging parameters and the actual charging parameters. The multiple initial charging parameters can be obtained by a battery experimental test platform in the fully discharging and full charging process of the battery. The fully discharging and full charging process includes:

S 1: At room temperature, the battery is discharged at a constant current at a first rate until the voltage of each cell in the battery reaches a first cut-off voltage.

S2: The battery stand is allowed to stand for a first preset period of time.

S3: At room temperature, the battery is charged at a constant current at a second rate until the voltage of each cell in the battery reaches a second cut-off voltage.

S4: The battery is allowed to stand for a second preset period of time.

S5: At room temperature, the battery is charged at a constant current at a third rate until the voltage of each cell in the battery reaches the second cut-off voltage.

The first rate, the first cut-off voltage, the first preset period of time, the second rate, the second cut-off voltage, the second preset period of time and the third rate can be preset according to the battery core characteristics of the battery. Illustratively, the first rate may be 0.3 C, the first cut-off voltage may be 2 V, the first preset period of time may be 1800s, the second rate may be 1 C, the second cut-off voltage may be 3.75 V, the second preset period of time may be 300s, and the third rate may be 0.2 C.

After the battery enters the full discharging and full charging process, that is, after the battery starts to discharge at a constant current at the first rate, the initial charging parameters of the battery can be collected periodically, where the collection interval can be determined according to the performance of a sampling circuit, Illustratively, the better the performance of the sampling circuit is, the shorter the sampling interval will be, for example, 50 ms; and the worse the performance of the sampling circuit is, the longer the sampling interval will be, for example, 100 ms, which are not limited in the present disclosure. After the battery is charged at a constant current at the third rate until the voltage of each cell in the battery reaches the second cut-off voltage, the collection of the initial charging parameters is stopped. Then, the initial charging parameters collected in the fully discharging and full charging process are stored in a server.

It should be noted that whether the current charging process is effective charging can also be determined in the current charging process of the battery in the present disclosure. Illustratively, the initial SOC of the battery and the charging temperature of the battery can be obtained at the beginning of the current charging process. Then, in the current charging process, the current SOC of the battery and the charging temperature of the battery can be obtained periodically. If the ranges covered the initial SOC and the current SOC include the preset SOC range and the minimum charging temperature of the battery is less than the preset temperature threshold, then the current charging process is effective charging, and multiple initial charging parameters of the battery can be acquired, Illustratively, if the preset SOC range is from 20% to 90% and the initial SOC of the battery acquired at the beginning of the current charging process is 15%, the current SOC of the battery can be obtained periodically in the current charging process. If it is determined that the current SOC reaches 90% and the minimum charging temperature of the battery in the process is less than or equal to the preset temperature threshold, the current charging process can be determined to be effective charging. As such, before the current charging process is completed, the current charging process is determined to be effective charging, and initial charging parameters of the battery are acquired. Therefore, the efficiency of estimating the battery capacity is improved.

S102: Multiple actual charging parameters of the battery in the current charging process and a current number of effective charging times corresponding to the current charging process are periodically acquired.

In this step, after the current charging process is started, the actual charging parameters of the battery are periodically acquired, where the method for setting the acquisition interval can be made reference to the collection period of the initial charging parameters, and will not be detailed here again. In addition, if the current charging process is determined to be effective charging, a current number of effective charging times corresponding to the current charging process can be determined. The current number of effective charging times can be determined according to a historical number of effective charging times. Illustratively, the current number of effective charging times may be the historical number of effective charging times plus 1. For example, if the historical number of effective charging times is 10, the current number of effective charging times is 11. In addition, one process of effective charging is completed by the battery, the historical number of effective charging times is increased by 1. For example, after the first process of effective charging is completed, the historical number of effective charging times is 1; and after the second process of effective charging is completed, the historical number of effective charging times is 2.

S103: According to the multiple initial charging parameters, the multiple actual charging parameters and the current number of effective charging times, a predicted battery capacity of the battery in a next effective charging process is acquired.

In this step, after acquiring the multiple initial charging parameters, the multiple actual charging parameters and the current number of effective charging times, a target number of charging times corresponding to the next effective charging process can be determined according to the historical number of effective charging times. Then, according to the multiple initial charging parameters, the multiple actual charging parameters, the current number of effective charging times and the target number of charging times, the predicted battery capacity of the battery in the next effective charging process is acquired.

By the method above, the predicted battery capacity of the battery in the next effective charging process can be acquired according to the multiple initial charging parameters, the multiple actual charging parameters and the current number of effective charging times. As such, the charging parameters of the battery can be acquired in an effective charging process of the battery with no need to stand still, to estimate a predicted battery capacity of the battery in a next effective charging process. Therefore, the efficiency of estimating the battery capacity is improved.

FIG. 2 is a flow chart of another method for acquiring a battery capacity according to an exemplary embodiment. As shown in FIG. 2, the method includes:

S201: Multiple initial charging parameters of a vehicle battery are acquired when a current charging process of the battery is effective charging.

The battery may be a power battery pack, the effective charging means that the range of variation in SOC of the battery in the current charging process covers a preset SOC range, and the minimum charging temperature of the battery in the current charging process is greater than or equal to a preset temperature threshold. The preset SOC range and the preset temperature threshold can be determined according to the material of the battery, and actual working conditions during use. Illustratively, three peak values, i.e. a first peak value, a second peak value and a third peak value, are present in SOC range of the battery. A predicted battery capacity of the battery in a next effective charging process can be acquired according to position information of the second peak value and position information of the third peak value in the present disclosure. Therefore, the preset SOC range can be set to a range including the second peak value and third peak value, for example, 20% to 90%; and the preset temperature threshold may be 10 °C, which are not limited in the present disclosure. If the range of variation in SOC of the battery is from 15% to 90% in the current charging process and the minimum charging temperature of the battery in the current charging process is 15 °C, it can be determined that the current charging process is effective changing. If the range of variation in SOC of the battery is from 15% to 80% in the current charging process and the minimum charging temperature of the battery in the current charging process is 7 °C, it can be determined that the current charging process is ineffective changing. In addition, the initial charging parameters can include an initial charging voltage and an initial charging current.

S202: Multiple actual charging parameters of the battery in the current charging process and a current number of effective charging times corresponding to the current charging process are periodically acquired.

The actual charging parameters can include an actual charging voltage and an actual charging current.

S203: According to the multiple initial charging parameters and the multiple actual charging parameters, a current maximum usable capacity of the battery is estimated.

In this step, after the multiple initial charging parameters and the multiple actual charging parameters are acquired, an initial capacity increment profile is acquired according to the initial charging parameters; an actual capacity increment profile is acquired according to the actual charging parameters; and a current maximum usable capacity of the battery is estimated according to the initial capacity increment profile and the actual capacity increment profile.

The initial capacity increment profile can be acquired through the following steps:

S1: A preset voltage interval is acquired.

The preset voltage interval may be preset. For example, the preset voltage interval is 5 mV, or 20 mV, which is not limited in the present disclosure.

S2: Multiple initial capacity increment values are acquired according to multiple initial charging currents and multiple initial charging voltages in the multiple initial charging parameters.

The capacity increment value is a capacity value corresponding to unit voltage increment. Illustratively, the initial capacity increment value can be calculated by a formula below:

$$IC_i = \frac{I_i}{dV_i/dt} \qquad (1)$$

where $IC_i$ is an ith initial capacity increment value, $I_i$ is an ith initial charging current, and $V_i$ is an ith initial charging voltage.

S3: The initial capacity increment profile is generated according to the preset voltage interval and the multiple capacity increment values.

After the preset voltage interval and the multiple initial capacity increment values, the initial capacity increment profile is generated through a method in related art with the voltage as the horizontal axis and the capacity increment value as the vertical axis according to the preset voltage interval.

It should be noted that after the initial capacity increment profile is acquired, the actual capacity increment profile can be acquired through a method as described for the initial capacity increment profile, which will not be detailed here again.

After the initial capacity increment profile and the actual capacity increment profile are acquired, first initial position information corresponding to a second peak value and second initial position information corresponding to a third peak value on the initial capacity increment profile are acquired; first current position information corresponding to a second peak value and second current position information corresponding to a third peak value on the actual capacity increment profile are acquired; and the current maximum usable capacity of the battery is estimated according to the first initial position information, the second initial position information, the first current position information, the second current position information, the initial charging parameters and the actual charging parameters.

After the first initial position information and the second initial position information are acquired, an initial interval capacity integral value is acquired according to the initial capacity increment profile, the first initial position information and the second initial position information. The initial interval capacity integral value is the capacity integral value between two peaks in the time interval between the second peak value and the third peak value. Illustratively, the initial interval capacity integral value is acquired by a formula below:

$$Q_c = \int_{t_{II}}^{t_{III}} I_i dt \qquad (2)$$

where Qc is the initial interval capacity integral value, tII is the first initial position information, tIII is the second initial position information, and Ii is an ith initial charging current.

It should be noted that after the initial capacity increment profile and the actual capacity increment profile are acquired, noses in the initial capacity increment profile and the actual capacity increment profile can be filtered off by preprocessing the initial capacity increment profile and the actual capacity increment profile by means algorithm, low-pass filtering and other methods. Therefore, a more precise initial capacity increment profile and actual capacity increment profile are obtained, so that the predicted battery capacity estimated according to the initial capacity increment profile and the actual capacity increment profile is more accurate.

In addition to the acquisition of the initial interval capacity integral value according to the position information of the second peak value and the third peak value of the initial capacity increment profile, the initial interval capacity integral value can also be calculated according to the area corresponding to a region between the second peak value and the third peak value, the slopes corresponding to the second peak value and the third peak value, and others, which is not limited in the present disclosure.

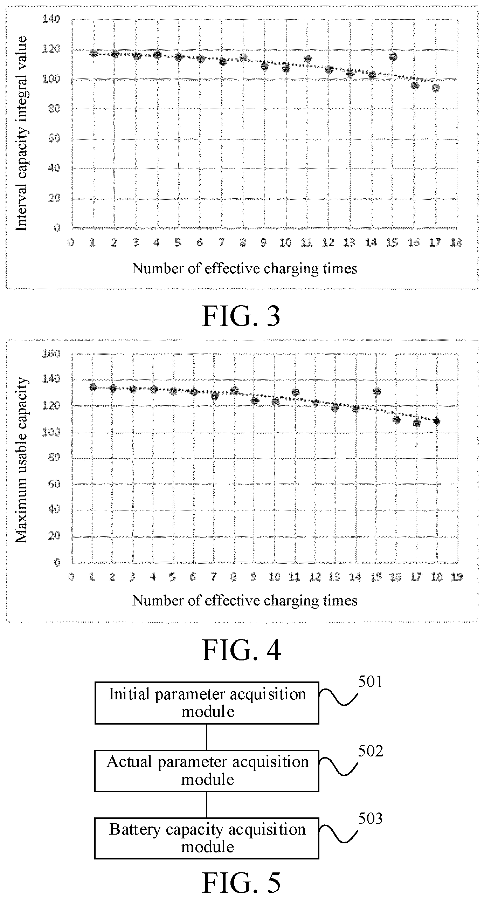

After the first current position information and the second current position information are acquired, an actual interval capacity integral value Qs can be acquired according to the actual charging parameters, the first current position information and the second current position information. The method for acquiring the actual interval capacity integral value can be made reference to the method for acquiring the initial interval capacity integral value, which will not be detailed here again. FIG. 3 is a schematic diagram showing an interval capacity integral value according to an exemplary embodiment, in which the horizontal axis is the number of effective charging times, and the vertical axis is the interval capacity integral value. As shown in FIG. 3, with increasing number of effective charging times, the interval capacity integral value becomes increasingly smaller, indicating an increasing battery loss.

Further, after obtaining the initial interval capacity integral value and the actual interval capacity integral value, the current maximum usable capacity of the battery can be calculated by a formula below.

$$Q_{max\_j} = \frac{Q_s}{Q_c} \cdot C \qquad (3)$$

where Qmax_j is the current maximum usable capacity, j is the current number of effective charging times, Qc is the initial interval capacity integral value, Qs is the actual interval capacity integral value, and C is an initial maximum usable capacity.

The initial maximum usable capacity can be calculated by a formula below:

$$C = \int_{t1}^{t2} I_i \, dt \qquad (4)$$

where C is the initial maximum usable capacity, t1 is a start sampling time corresponding to the initial charging parameters, t2 is an end sampling time corresponding to the initial charging parameters, and Ii is an ith initial charging current.

FIG. 4 is a schematic diagram showing a maximum usable capacity according to an exemplary embodiment, where the horizontal axis is the number of effective charging times, and the vertical axis is the maximum usable capacity. As shown in FIG. 4, with increasing number of effective charging times, the maximum usable capacity of the battery becomes increasingly smaller, indicating an increasing battery loss.

S204: A capacity correlation relation is acquired according to the current maximum usable capacity and the current number of effective charging times.

The capacity correlation relation includes a correspondence relation between the predicted battery capacity and the number of effective charging times.

In this step, after the current maximum usable capacity and the current number of effective charging times are acquired, the capacity correlation relation is acquired according to the current maximum usable capacity and the current number of effective charging times:

$$Q_{max\_j} = \frac{Q_s}{Q_c} \cdot C = \frac{f(X_{charge})}{Q_c} \cdot C = g(X_{charge}) \qquad (5)$$

where Qmax_j is the predicted battery capacity in case of effective charging, and Xcharge is the number of effective charging times.

Through the conversion by Formula (5), the correspondence relation Qmax_j= g(Xcharge) between the predicted battery capacity and the effective number of effective charging times can be obtained. To improve the accuracy of the predicted battery capacity, after the current maximum usable capacity is acquired, the capacity correlation relation can be fitted according to the current maximum usable capacity, the current number of effective charging times, a historical maximum usable capacity in all effective charging process before the current charging process, and a historical number of effective charging times.

In a possible implementation, before the capacity correlation relation is acquired according to the current maximum usable capacity and the current number of effective charging times, the historical maximum usable capacity in all effective charging processes before the current charging process and the historical number of effective charging times corresponding to the historical maximum usable capacity are acquired. The capacity correlation relation is acquired according to the current maximum usable capacity, the current number of effective charging times, the historical maximum usable capacity and the historical number of effective charging times.

The method for calculating the historical maximum usable capacity can be made reference to the method for calculating the current maximum usable capacity, which will not be detailed here again. After the current maximum usable capacity, the current number of effective charging times, the historical maximum usable capacity and the historical number of effective charging times, the capacity correlation relation can be obtained by fitting, including exponential fitting, linear fitting, logarithmic fitting, polynomial fitting, and power function fitting, etc., which is not limited in the present disclosure. Here, the specific fitting method can be made reference to the implementation of related technologies, which will not be detailed here again.

Illustratively, the capacity correlation relation obtained by fitting can be Formula (6) or Formula (7):

$$y = -0.0853x^2 + 0.1721x + 133.87 \qquad (6)$$

$$y = 140.13e^{-0.012x} \qquad (7)$$

where y is the predicted battery capacity, and x is the number of effective charging times.

It should be noted that the capacity correlation relation expressed by Formula (6) and Formula (7) is merely exemplary (an expression obtained from experimental data), and different capacity correlation relations can be obtained by different fitting methods for different batteries, in different use environments, which are not limited in the present disclosure.

S205: A predicted battery capacity of the battery in a next effective charging process is acquired from the capacity correlation relation.

In this step, after the capacity correlation relation is acquired, a target number of charging times corresponding to the next effective charging process is acquired; and the predicted battery capacity of the battery in the next effective charging process is acquired according to the target number of charging times and the capacity correlation relation. Illustratively, the predicted battery capacity can be calculated by introducing the target number of charging times into Formula (6) or (7). For example, if the target number of charging times is 10, the predicted battery capacity is calculated to be 144.121 by Formula (6).

By the method above, the capacity correlation relation can be acquired according to the current maximum usable capacity, the current number of effective charging times, the historical maximum usable capacity and the historical number of effective charging times and the predicted battery capacity of the battery in the next effective charging process is acquired from the capacity correlation relation. As such, the predicted battery capacity is obtained through calculation from the capacity correlation relation. Therefore, the efficiency of estimating the battery capacity is improved. In addition, the capacity correlation relation is acquired based on the charging parameters in the process of full discharging and full charging and historically accumulated parameters of all effective charging processes, so the accuracy of the capacity correlation relation is higher. Therefore, the predicted battery capacity obtained according to the capacity correlation relation has higher accuracy.

FIG. 5 is a schematic structural diagram of a device for acquiring a battery capacity according to an exemplary embodiment. As shown in FIG. 5, the device includes:

an initial parameter acquisition module 501, configured to acquire multiple initial charging parameters of a vehicle battery when a current charging process of the battery is effective charging, where the effective charging means that the range of variation in SOC of the battery in the current charging process covers a preset SOC range, and the minimum charging temperature of the battery in the current charging process is greater than or equal to a preset temperature threshold;

an actual parameter acquisition module 502, configured to periodically acquire multiple actual charging parameters of the battery in the current charging process and a current number of effective charging times corresponding to the current charging process; and

a battery capacity acquisition module 503, configured to acquire, according to the multiple initial charging parameters, the multiple actual charging parameters and the current number of effective charging times, a predicted battery capacity of the battery in a next effective charging process.

Optionally, the battery capacity acquisition module 503 is further configured to: estimate a current maximum usable capacity of the battery according to the multiple initial charging parameters and the multiple actual charging parameters; acquire a capacity correlation relation according to the current maximum usable capacity and the current number of effective charging times, where the capacity correlation relation includes a correspondence relation between the predicted battery capacity and the number of effective charging times; and acquire the predicted battery capacity of the battery in the next effective charging process from the capacity correlation relation.

Optionally, the battery capacity acquisition module 503 is further configured to: acquire an initial capacity increment profile according to the initial charging parameters; acquire an actual capacity increment profile according to the actual charging parameters; and estimate the current maximum usable capacity of the battery according to the initial capacity increment profile and the actual capacity increment profile.

Optionally, the battery capacity acquisition module 503 is further configured to: acquire first initial position information corresponding to a second peak value and second initial position information corresponding to a third peak value on the initial capacity increment profile; acquire first current position information corresponding to a second peak value and second current position information corresponding to a third peak value on the actual capacity increment profile; and estimate the current maximum usable capacity of the battery according to the first initial position information, the second initial position information, the first current position information, the second current position information, the initial charging parameters and the actual charging parameters.

Optionally, the battery capacity acquisition module 503 is further configured to: acquire a target number of charging times corresponding to the next effective charging process; and acquire, according to the target number of charging times and the capacity correlation relation, the predicted battery capacity of the battery in the next effective charging process from the capacity correlation relation.

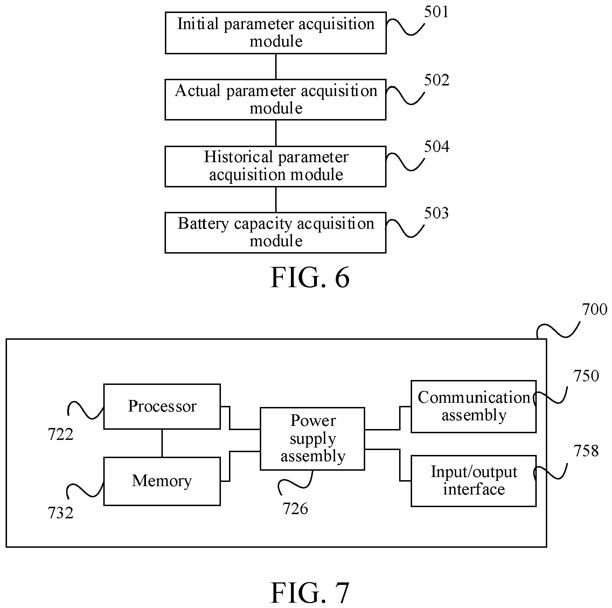

FIG. 6 is a schematic structural diagram of another device for acquiring a battery capacity according to an exemplary embodiment. As shown in FIG. 6, the device further includes:

a historical parameter acquisition module 504, configured to acquire a historical maximum usable capacity in all effective charging processes before the current charging process and a historical number of effective charging times corresponding to the historical maximum usable capacity.

The battery capacity acquisition module 503 is further configured to: acquire the capacity correlation relation according to the current maximum usable capacity, the current number of effective charging times, the historical maximum usable capacity and the historical number of effective charging times.

By using the device, the predicted battery capacity of the battery in the next effective charging process can be obtained according to the multiple initial charging parameters, the multiple actual charging parameters and the current number of effective charging times. As such, the charging parameters of the battery can be acquired in an effective charging process of the battery with no need to stand still, to estimate a predicted battery capacity of the battery in a next effective charging process. Therefore, the efficiency of estimating the battery capacity is improved.

For the device in the embodiments above, a specific manner in which each module performs an operation is already described in detail in the embodiments concerning the method, and details are not described herein again.

FIG. 7 is a block diagram of a server according to an exemplary embodiment. For example, the server 700 may be provided as a server. Referring to FIG. 7, the server 700 includes one or more processors 722, and a memory 732, configured to store a computer program executable by the processor 722. The computer program stored in the memory 732 can include one or more modules each corresponding to a set of instructions. Moreover, the processor 722 can be configured to execute the computer program to perform the method for acquiring a battery capacity.

In addition, the server 700 may further include a power supply assembly 726 and a communication assembly 750. The power supply assembly 726 can be configured to perform power management on the electronic device 700, and the communication assembly 750 can be configured to implement the communication of the server 700, for example, wired or wireless communication. Moreover, the server 700 may further include an input/output (I/O) interface 758. The server 700 may operate an operating system stored in the memory 732, such as Windows ServerTM, Mac OS XTM, UnixTM, and LinuxTM.

In another exemplary embodiment, a computer-readable storage medium storing a program instruction is further provided. The program instruction, when executed by a processor, implements steps of the method for acquiring a battery capacity. For example, the computer-readable storage medium may be the memory 732 storing the program instruction. The program instruction is executed by the process 722 of the server 700 to implement the method for acquiring a battery capacity.

In another exemplary embodiment, a computer program product is further provided, which includes a computer program executable by a programmable device. The computer program has codes that implements, when executed by the programmable device, the method for acquiring a battery capacity.

Preferred embodiments of the present disclosure have been described in detail above with reference to the accompanying drawings. However, the present disclosure is not limited to the specific details in the foregoing embodiments. Within the scope of the technical concept of the present disclosure, a variety of simple modifications can be made to the technical solution of the present disclosure, which fall within the protection scope of the present disclosure. In addition, it should be noted that the various specific technical features described in the foregoing specific embodiments can be combined in any suitable manner, where there is no contradiction. In order to avoid unnecessary repetition, various possible combinations are not described separately in the present disclosure.

Moreover, different embodiments of the present disclosure can also be arbitrarily combined without departing from the idea of the present disclosure, and these combinations shall still be regarded as content disclosed in the present disclosure.

## Claims

1.    A method for acquiring a battery capacity, comprising:

   acquiring multiple initial charging parameters of a vehicle battery when a current charging process of the battery is effective charging, wherein the effective charging means that the range of variation in SOC of the battery in the current charging process covers a preset SOC range, and the minimum charging temperature of the battery in the current charging process is greater than or equal to a preset temperature threshold;
   periodically acquiring multiple actual charging parameters of the battery in the current charging process and a current number of effective charging times corresponding to the current charging process; and
   acquiring, according to the multiple initial charging parameters, the multiple actual charging parameters and the current number of effective charging times, a predicted battery capacity of the battery in a next effective charging process.

2.    The method according to claim 1, wherein the step of acquiring, according to the multiple initial charging parameters, the multiple actual charging parameters and the current number of effective charging times, a predicted battery capacity of the battery in a next effective charging process comprises:

   estimating, according to the multiple initial charging parameters and the multiple actual charging parameters, a current maximum usable capacity of the battery;
   acquiring, according to the current maximum usable capacity and the current number of effective charging times, a capacity correlation relation, wherein the capacity correlation relation comprises a correspondence relation between the predicted battery capacity and the number of effective charging times; and
   acquiring, according to the capacity correlation relation, the predicted battery capacity of the battery in the next effective charging process.

3.    The method according to claim 2, wherein the step of estimating, according to the multiple initial charging parameters and the multiple actual charging parameters, a current maximum usable capacity of the battery comprises:

   acquiring, according to the initial charging parameters, an initial capacity increment profile;
   acquiring, according to the actual charging parameters, an actual capacity increment profile; and
   estimating, according to the initial capacity increment profile and the actual capacity increment profile, the current maximum usable capacity of the battery.

4.    The method according to claim 3, wherein the step of estimating, according to the initial capacity increment profile and the actual capacity increment profile, the current maximum usable capacity of the battery comprises:

   acquiring first initial position information corresponding to a second peak value and second initial position information corresponding to a third peak value on the initial capacity increment profile;

acquiring a first current position information corresponding to a second peak value and a second current position information corresponding to a third peak value on the actual capacity increment profile; and
estimating, according to the first initial position information, the second initial position information, the first current position information, the second current position information, the initial charging parameters and the actual charging parameters, the current maximum usable capacity of the battery.

5. The method according to claim 2, wherein the step of acquiring, according to the capacity correlation relation, the predicted battery capacity of the battery in the next effective charging process comprises:

acquiring a target number of charging times corresponding to the next effective charging process; and
acquiring, according to the target number of charging times and the capacity correlation relation, the predicted battery capacity of the battery in the next effective charging process.

6. The method according to any one of claims 2 to 5, further comprising, before the step of acquiring, according to the current maximum usable capacity and the current number of effective charging times, a capacity correlation relation,

acquiring a historical maximum usable capacity in various effective charging processes before the current charging process and a historical number of effective charging times corresponding to the historical maximum usable capacity; and
the step of acquiring, according to the current maximum usable capacity and the current number of effective charging times, a capacity correlation relation comprises:
acquiring, according to the current maximum usable capacity, the current number of effective charging times, the historical maximum usable capacity and the historical number of effective charging times, the capacity correlation relation.

7. A device for acquiring a battery capacity, comprising:

an initial parameter acquisition module, configured to acquire multiple initial charging parameters of a vehicle battery when a current charging process of the battery is effective charging, wherein the effective charging means that the range of variation in SOC of the battery in the current charging process covers a preset SOC range, and the minimum charging temperature of the battery in the current charging process is greater than or equal to a preset temperature threshold;
an actual parameter acquisition module, configured to periodically acquire multiple actual charging parameters of the battery in the current charging process and a current number of effective charging times corresponding to the current charging process; and
a battery capacity acquisition module, configured to acquire, according to the multiple initial charging parameters, the multiple actual charging parameters and the current number of effective charging times, a predicted battery capacity of the battery in a next effective charging process.

8. The device according to claim 7, wherein the battery capacity acquisition module is further configured to:

estimate, according to the multiple initial charging parameters and the multiple actual charging parameters, a current maximum usable capacity of the battery;
acquire, according to the current maximum usable capacity and the current number of effective charging times, a capacity correlation relation, wherein the capacity correlation relation comprises a correspondence relation between the predicted battery capacity and the number of effective charging times; and
acquire, according to the capacity correlation relation, the predicted battery capacity of the battery in the next effective charging process.

9. The device according to claim 8, wherein the battery capacity acquisition module is further configured to:

acquiring, according to the initial charging parameters, an initial capacity increment profile;
acquiring, according to the actual charging parameters, an actual capacity increment profile; and
estimate, according to the initial capacity increment profile and the actual capacity increment profile, the current maximum usable capacity of the battery.

10. The device according to claim 9, wherein the battery capacity acquisition module is further configured to:

acquire first initial position information corresponding to a second peak value and second initial position information corresponding to a third peak value on the initial capacity increment profile;

acquire first current position information corresponding to a second peak value and second current position information corresponding to a third peak value on the actual capacity increment profile; and

estimate, according to the first initial position information, the second initial position information, the first current position information, the second current position information, the initial charging parameters and the actual charging parameters, the current maximum usable capacity of the battery.

**11.** The device according to claim 8, wherein the battery capacity acquisition module is further configured to:

acquire a target number of charging times corresponding to the next effective charging process; and
acquire, according to the target number of charging times and the capacity correlation relation, the predicted battery capacity of the battery in the next effective charging process.

**12.** The device according to any one of claims 8 to 11, further comprising:

a historical parameter acquisition module, configured to acquire a historical maximum usable capacity in various effective charging processes before the current charging process and a historical number of effective charging times corresponding to the historical maximum usable capacity;
wherein the battery capacity acquisition module is further configured to:
acquiring, according to the current maximum usable capacity, the current number of effective charging times, the historical maximum usable capacity and the historical number of effective charging times, the capacity correlation relation.

**13.** A computer readable storage medium, storing a computer program, wherein the computer program, when executed by a processor, implements steps of the method according to any one of claims 1 to 6.

**14.** A server, comprising:

a memory, storing a computer program; and
a processor, configured to execute the computer program in the memory, to implement steps of the method according to any one of claims 1 to 6.

| Multiple initial charging parameters of a vehicle battery are acquired when a current charging process of the battery is effective charging | S101 |

| Multiple actual charging parameters of the battery in the current charging process and a current number of effective charging times corresponding to the current charging process are periodically acquired. | S102 |

| According to the multiple initial charging parameters, the multiple actual charging parameters and the current number of effective charging times, a predicted battery capacity of the battery in a next effective charging process is acquired. | S103 |

FIG. 1

| Multiple initial charging parameters of a vehicle battery are acquired when a current charging process of the battery is effective charging | S201 |

| Multiple actual charging parameters of the battery in the current charging process and a current number of effective charging times corresponding to the current charging process are periodically acquired | S202 |

| According to the multiple initial charging parameters and the multiple actual charging parameters, a current maximum usable capacity of the battery is estimated. | S203 |

| A capacity correlation relation is acquired according to the current maximum usable capacity and the current number of effective charging times | S204 |

| A predicted battery capacity of the battery in a next effective charging process is acquired from the capacity correlation relation | S205 |

FIG. 2

FIG. 3

FIG. 4

FIG. 5

Initial parameter acquisition module — 501

Actual parameter acquisition module — 502

Historical parameter acquisition module — 504

Battery capacity acquisition module — 503

## FIG. 6

700

750

Processor
722

Power supply assembly

Communication assembly

Memory
732

726

Input/output interface
758

## FIG. 7

## INTERNATIONAL SEARCH REPORT

International application No.

**PCT/CN2021/119637**

### A. CLASSIFICATION OF SUBJECT MATTER

G01R 31/387(2019.01)i

According to International Patent Classification (IPC) or to both national classification and IPC

### B. FIELDS SEARCHED

Minimum documentation searched (classification system followed by classification symbols)

G01R

Documentation searched other than minimum documentation to the extent that such documents are included in the fields searched

Electronic data base consulted during the international search (name of data base and, where practicable, search terms used)

CNTXT; CNKI; ENTXTC; VEN: 电池, 容量, 循环, 充电, 放电, 次数, 计数, 有效, 可用容量, 容量增量曲线, IC曲线, dQ, dU, 曲线, 微分, capacity, charge, discharge, cycle, available capacity, increment capacity curve, IC curve, differential

### C. DOCUMENTS CONSIDERED TO BE RELEVANT

| Category* | Citation of document, with indication, where appropriate, of the relevant passages | Relevant to claim No. |
|---|---|---|
| X | CN 105068009 A (YANCHENG INSTITUTE OF TECHNOLOGY) 18 November 2015 (2015-11-18) claims 1-2, description paragraphs 25-34 | 1-14 |
| A | CN 103823191 A (AVIC TIANJIN AVIAT ELECTRO MECHANICAL CO., LTD.) 28 May 2014 (2014-05-28) entire document | 1-14 |
| A | CN 110568361 A (HUAZHONG UNIVERSITY OF SCIENCE AND TECHNOLOGY) 13 December 2019 (2019-12-13) entire document | 1-14 |
| A | US 2020203780 A1 (SAMSUNG ELECTRONICS CO., LTD.) 25 June 2020 (2020-06-25) entire document | 1-14 |
| A | CN 107045104 A (BEIJING JIAOTONG UNIVERSITY et al.) 15 August 2017 (2017-08-15) entire document | 1-14 |
| A | US 2012150465 A1 (NAKASHIMA RYOICHI et al.) 14 June 2012 (2012-06-14) entire document | 1-14 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **15 December 2021** | **27 December 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

| | International application No. |
|---|---|
| | **PCT/CN2021/119637** |

| Patent document cited in search report | | | Publication date (day/month/year) | Patent family member(s) | | | Publication date (day/month/year) |
|---|---|---|---|---|---|---|---|
| CN | 105068009 | A | 18 November 2015 | CN | 105068009 | B | 20 October 2017 |
| CN | 103823191 | A | 28 May 2014 | CN | 103823191 | B | 08 June 2016 |
| CN | 110568361 | A | 13 December 2019 | CN | 110568361 | B | 08 September 2020 |
| US | 2020203780 | A1 | 25 June 2020 | WO | 2020130422 | A1 | 25 June 2020 |
| | | | | IN | 201811048646 | A | 21 August 2020 |
| CN | 107045104 | A | 15 August 2017 | CN | 107045104 | B | 31 December 2019 |
| US | 2012150465 | A1 | 14 June 2012 | US | 9153848 | B2 | 06 October 2015 |
| | | | | CN | 102566199 | A | 11 July 2012 |
| | | | | EP | 2466680 | A1 | 20 June 2012 |
| | | | | JP | 2012127744 | A | 05 July 2012 |
| | | | | TW | 201239382 | A | 01 October 2012 |
| | | | | IN | 201103543 | I1 | 18 January 2013 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202011066177